(19) Europäisches Patentamt
European Patent Office
Office européen des brevets

(11) **EP 2 649 723 B1**

(12) **EUROPEAN PATENT SPECIFICATION**

(45) Date of publication and mention
of the grant of the patent:
**09.11.2016 Bulletin 2016/45**

(51) Int Cl.:
***H02P 23/14*** *(2006.01)* ***G01R 25/04*** *(2006.01)*

(21) Application number: **11801899.3**

(22) Date of filing: **23.11.2011**

(86) International application number:
**PCT/US2011/062018**

(87) International publication number:
**WO 2012/078367 (14.06.2012 Gazette 2012/24)**

(54) **COMPLEX ADAPTIVE PHASE ESTIMATION**

KOMPLEXE ADAPTIVE PHASENSCHÄTZUNG

ESTIMATION DE PHASE ADAPTATIVE COMPLEXE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.12.2010 US 961056**

(43) Date of publication of application:
**16.10.2013 Bulletin 2013/42**

(73) Proprietor: **Schneider Electric USA, Inc.
Andover, MA 01810 (US)**

(72) Inventor: **TURNER, Larry, A.
Chapel Hill
North Carolina 27516 (US)**

(74) Representative: **Zerbi, Guido Maria
Murgitroyd & Company
Piazza Borromeo, 12
20123 Milano (IT)**

(56) References cited:
**JP-A- H05 292 781     US-A1- 2009 287 463**

**Description**

**FIELD OF THE INVENTION**

The present disclosure relates generally to estimating the phase difference between complex signals, and more particularly to systems, methods, and devices for accurately estimating the phase difference between a complex primary signal and a complex incident signal.

**BACKGROUND**

Robust accurate transient slip estimation is fundamental to achieving a significant measure of success in several types of motor analysis. Established techniques often explicitly or implicitly assume stationary or quasi-stationary motor operation. In practicality, however, motor and load environments are dynamic and dependent on a myriad of variables, such as internal and external temperature, varying load dynamics, fundamental frequency and voltage, etc. The cumulative effects of such variations can have a significant detrimental effect on many types of motor analysis.

Model Referencing Adaptive System (MRAS) is a method of iteratively adapting an electrical model of a three-phase induction motor with significant performance advantages over competitive approaches assuming quasi-stationary motor operation, as the assumption of stationary operation is often violated, with detrimental effect on model accuracy. MRAS is highly dependent upon availability of robust transient slip estimation. Applications benefiting from accurate transient slip estimation include, but are not limited to, synthesis of high quality electrical and thermal motor models, precision electrical speed estimation, dynamic efficiency and output power estimation, and inverter-fed induction machines employing vector control.

Slip estimation can be performed by passive analysis of the voltage and current signals of a three-phase induction motor, and commonly available motor-specific parameters. In a stationary environment, slip estimation accuracy is optimized by increasing the resolution of the frequency, or degree of certainty of the frequency estimate. As motor operation is typically not stationary, robust slip estimation also depends upon retention of sufficient temporal resolution, such that the unbiased transient nature of the signal is observed.

Frequency estimation is commonly performed by Fourier analysis. Fourier analysis is frame-based, operating on a contiguous temporal signal sequence defined over a fixed period of observation. Frequency resolution, defined as the inverse of the period of observation, can be improved by extending the period of observation. Moderate improvement in effective frequency resolution can be realized through local frequency interpolation and other techniques that are generally dependent on *a priori* knowledge of the nature of the observed signal.

In Fourier analysis, it is implicit that source signals are stationary over the period of observation, or practically that they are stationary over contiguous temporal sequences that commonly exceed the period of observation in some statistical sense. Fourier analysis can be inappropriate for application in environments where a signal of interest violates the stationary condition implicit in the definition of a specific period of observation. Such instances may result in an aggregate frequency response and loss of transient information determined to be important to analysis. Fourier analysis presents a temporal range versus frequency resolution dilemma. At periods of observation to resolve a saliency harmonic frequency with sufficient accuracy, the stationary condition is violated and important transient information is not observable.

An effective saliency harmonic frequency resolution of less than 0.1 Hz may be defined to be minimally sufficient, resulting in a requisite period of observation of 10 seconds, which may be reduced to no less than 1.0 second through application of local frequency interpolation. However, saliency harmonic frequency variations exceeding 10.0 Hz are not uncommon. The relative transient nature of such signals violates the stationary condition requirement implicit in the definition of the minimum period of observation. Fourier analysis is not suitable for employment in robust accurate slip estimation, in applications where preservation of significant transient temporal response is important.

There is a continuing need for accurate phase estimation that exhibits, for example, rapid convergence, low computational complexity, and low storage requirements. US2009/0287463 is an example of prior art method and system for phase estimation.

JPH05292781 discloses a drive controller for brushless servomotor comprising a phase difference detecting circuit 13 operating phase difference between the current reference signal Ic' and a current feedback signal If.

**SUMMARY**

A Complex Adaptive Phase Estimation (PE) filter, as presented in some concepts of the present disclosure, is an adaptive filter that accurately estimates the phase difference between two complex signals of arbitrary phase. For example, the PE filter can estimate the phase difference between a complex primary signal and a complex incident signal, iteratively adapting the phase of a complex exponential by minimizing the mean squared error of a complex error signal. The complex adaptive PE filter can extract accurate differential or absolute phase estimates of complex signals in a flexible and computationally efficient form. The PE filter can demonstrate accurate phase estimation and rapid convergence, with low computational complexity and low storage requirements relative to other known methods.

Absolute phase estimation of a single complex signal can be supported in a simplification of the PE filter construction. Simplification of the PE filter construction is, in some configurations, equivalent to assigning the complex incident signal a value of unity, which further reduces computational complexity. The PE filter can support simple, practical implementation in environments with minimal computational resources. Efficient complex normalization approximation is also developed to support practical PE filter implementation in computationally restrictive environments, including systems with real-time response constraints, and systems without efficient native or functional support for division or square root operations.

The architectures and means of adaptation are unique and have broad application in many application domains. Potential applications include, but are not limited to, arctangent estimation, fractional-sample latency compensation, delay estimation, frame and bit synchronization, and Phase Modulation (PM) demodulation.

The present invention is defined in claim 1.

According to some aspects of the present disclosure, a method of estimating a phase difference between a complex primary signal and a complex incident signal is presented. The method includes: iteratively adapting a phase of a complex exponential by minimizing a mean squared error norm of a complex error signal; and responsive to the mean squared error norm being minimized, storing the phase difference between the complex primary signal and the complex incident signal.

According to other aspects of the present disclosure, a method of estimating an absolute phase of a complex primary signal is featured. The method includes: normalizing the complex primary signal to produce a normalized complex primary signal; iteratively adapting a phase of a complex exponential of an iteratively normalized phase estimate by minimizing a mean squared error norm of a complex error signal corresponding to a difference between the normalized complex primary signal and a complex reference signal produced by the complex exponential; and storing the absolute phase of the complex primary signal responsive to the normalized phase approximating an absolute normalized phase of the complex primary signal.

According to other aspects of the present disclosure, a method of estimating a phase difference between a primary signal and a reference signal is disclosed. The method includes: determining a normalized primary signal based, at least in part, on the primary signal; determining a normalized reference signal based, at least in part, on the reference signal; determining a complex reference signal, the complex reference signal being the product of the normalized reference signal and a complex exponential; determining a complex error signal, the complex error signal being the difference between the normalized primary signal and the complex reference signal; iteratively adapting a phase of the complex exponential by minimizing a norm of the complex error signal; and storing the phase difference between the complex primary signal and the complex incident signal when the norm is minimized.

The above summary is not intended to represent each embodiment or every aspect of the present disclosure. Rather, the foregoing summary merely provides an exemplification of some of the novel features disclosed herein. The above features and advantages, and other features and advantages of the present disclosure, will be readily apparent from the following detailed description of the exemplary embodiments and best modes for carrying out aspects of the present invention when taken in connection with the accompanying drawings and appended claims.

## BRIEF DESCRIPTION OF THE DRAWINGS

FIGURE 1 is a schematic block diagram showing the overall architecture of an exemplary adaptive phase estimation (PE) filter.

FIGURE 2 is a graph showing an exemplary performance surface synthesized from a PE filter.

FIGURE 3 is a graph showing an exemplary normalized phase estimation absolute error illustrated on a logarithmic scale over the contiguous range of a normalized phase.

FIGURE 4 is a graph showing an exemplary mean absolute error and an exemplary maximum absolute error of an exemplary complex normalized phase estimation error illustrated on a logarithmic scale over a normalized phase iteration quantity.

FIGURE 5 is a schematic block diagram showing the overall architecture of an exemplary absolute PE filter.

While the present disclosure is susceptible to various modifications and alternative forms, specific embodiments have been shown by way of example in the drawings and will be described in detail herein.

## DETAILED DESCRIPTION OF THE EXEMPLARY EMBODIMENTS

A complex adaptive Phase Estimation (PE) filter, as presented in some concepts of the present disclosure, is an adaptive filter that accurately estimates the phase difference between two complex signals of arbitrary phase. The PE filter can demonstrate accurate phase estimation and rapid convergence, with low computational complexity and low storage requirements relative to other known methods. The PE filter differential architecture can estimate the phase difference between a complex primary signal and a complex incident signal, iteratively adapting the phase of a complex exponential by minimizing the mean squared error of a complex error signal.

Absolute phase estimation of a single complex signal can be supported in a simplification of the PE filter construction. In some configurations, the PE filter absolute architecture is equivalent to the differential architecture, with one significant simplification: the complex incident signal is assigned a constant value of unity, resulting in an absolute phase estimation of the complex primary signal relative to zero phase.

In environments where efficient complex exponential synthesis is not available, the complex exponential operation can be accurately and efficiently approximated. In some configurations, the complex exponential operation can be accurately and efficiently approximated, for example, in the form of an indexed table, at any resolution required, limited only by available storage and numerical representation.

Multiple iterations of the phase estimation are required per sample of the complex primary and complex incident signals to achieve a specified accuracy. Normalized phase iteration quantity, K, is an application-dependent limit defining the quantity of iterative normalized phase estimates, with index, k, to be determined per sample of the complex primary and complex incident signals. It is possible to select the normalized phase iteration quantity to ensure that the mean absolute error, $L_1$, or maximum absolute error, $L_\infty$, of the resulting normalized phase estimation error is within acceptable bounds for an application in a specific environment. Computational complexity is typically proportional to normalized phase iteration quantity, K.

The $L_1$ or $L_\infty$ norm of the normalized phase estimation error decreases exponentially with respect to increasing normalized phase iteration quantity, at a rate equal to approximately 6.2 bits of increase in dynamic range per iteration. At a normalized phase iteration quantity greater than 8, the reduction in estimation error is negligible, and the error is bound at the limit by other existing sources of error, including misadjustment, numerical representation, and finite word length effects.

At the limit, the dynamic range of a numerical representation is often insufficient to represent the accuracy promised by an incrementally larger polynomial segment length. A signed error on the scale of 3.8e-9, as observed at normalized phase iteration quantity equal to 4, represents over 28 bits of dynamic range. A normalized phase iteration quantity greater than or equal to 8 results in signed error on the scale of 1.0e-16, representing over 54 bits of dynamic range.

Applications that can benefit from accurate phase estimation include, but are not limited to, dynamic motor efficiency and power factor estimation, latency compensation, group delay estimation, frame and bit synchronization, and phase demodulation.

## COMPLEX ADAPTIVE PHASE ESTIMATION FILTER

Concepts of normalized frequency, normalized phase, complex dot and cross products, and norms are introduced as convenient constructs in the subsequent definitions.

As seen in equation **(1.1),** below, normalized frequency, *f*, is the absolute frequency divided by the Nyquist frequency, and is defined over the range [-1, 1], corresponding to the absolute frequency range [-0.5·$f_s$, 0.5·$f_s$] Hz.

$$f = \frac{2 \cdot f_{HZ}}{f_s} \qquad \textbf{(1.1)}$$

Normalized phase, $\phi$, as seen in equation **(1.2),** below, is the absolute phase divided by $\pi$, and is defined over the range [-1, 1], corresponding to the absolute phase range [-$\pi$, $\pi$] radians.

$$\phi = \frac{\phi_{RAD}}{\pi} \qquad \textbf{(1.2)}$$

According to equation **(1.3),** normalized frequency, $f_n$, is defined as the discrete time derivative of the normalized phase, $\phi_n$, with respect to sample index n.

$$f_n = \frac{d}{dn}\left(\phi_n\right) \qquad\qquad (1.3)$$

Dot product and cross product are defined as vector operators, with two vector arguments defined in a three-dimensional Euclidean space. For the purpose of notational simplification, it is convenient to define dot product and cross product as complex operators, with two complex quantities as inputs, producing real results. Vector inputs are constructed from the orthogonal real and imaginary components of the complex quantities, projected into a Euclidean space.

The complex dot product operator, $\odot$, represents the tangential component of the product of two complex inputs, x and *y*, as seen below in equation **(1.4)**. Real and imaginary components of the complex inputs, x and *y*, are defined by $x_{RE}$ and $x_{IM}$, and $y_{RE}$ and $y_{IM}$, respectively. The complex dot product is commutative.

$$x \odot y = x^* \odot y^* = y \odot x = x_{RE} \cdot y_{RE} + x_{IM} \cdot y_{IM} \qquad\qquad (1.4)$$

Equation **(1.5)**, which is presented below, demonstrates that the complex cross product operator, $\otimes$, represents the normal component of the product of two complex inputs, x and *y*. In contrast to the complex dot product, the complex cross product is not commutative.

$$x \otimes y = -x^* \otimes y^* = -y \otimes x = x_{RE} \cdot y_{IM} - x_{IM} \cdot y_{RE} \qquad\qquad (1.5)$$

It is often convenient to express complex multiplication in terms of complex dot product and cross product operations. In equation **(1.6)**, substituting equations **(1.4)** and **(1.5)** expressed in terms of $x^*$ and *y*.

$$x \cdot y = \left(x_{RE} \cdot y_{RE} - x_{IM} \cdot y_{IM}\right) + j \cdot \left(x_{RE} \cdot y_{IM} + x_{IM} \cdot y_{RE}\right) = \left(x^* \odot y\right) + j \cdot \left(x^* \otimes y\right) \qquad (1.6)$$

A norm is a measure of difference between two signals, a primary signal, and an estimated reference signal, over some period of observation. The norm is an aggregate or statistical representation of the difference, or error. Norm specifications commonly employed include $L_1$, which represents the mean absolute error, $L_2$, which represents the mean squared error, and $L_\infty$, which represents the maximum absolute error.

The $L_1$ norm of normalized frequency estimation is defined as the mean absolute error, or difference between a primary signal, $x_n$, and an estimated reference signal, $y_n$, over a period of observation, N, as seen in equation **(1.7)**.

$$L_1 = \left(\frac{1}{N}\right) \cdot \sum_{n=0}^{N-1} \left|x_n - y_n\right| \qquad\qquad (1.7)$$

The $L_2$ norm of normalized frequency estimation is defined as the mean squared error, or difference between a primary signal, $x_n$, and an estimated reference signal, $y_n$, over a period of observation, N, as seen in equation (1.8).

$$L_2 = \left(\frac{1}{N}\right) \cdot \sum_{n=0}^{N-1} \left(x_n - y_n\right) \cdot \left(x_n - y_n\right)^* \qquad\qquad (1.8)$$

The $L_\infty$ norm of normalized frequency estimation is defined as the maximum absolute error, or difference between a primary signal, $x_n$, and an estimated reference signal, $y_n$, over a period of observation, N, as seen in equation **(1.9)**.

$$L_\infty = \mathrm{MAX}\left(\left|x_n - y_n\right|\right) \qquad\qquad n:\left[0, N-1\right] \qquad\qquad (1.9)$$

## Differential Phase Estimation

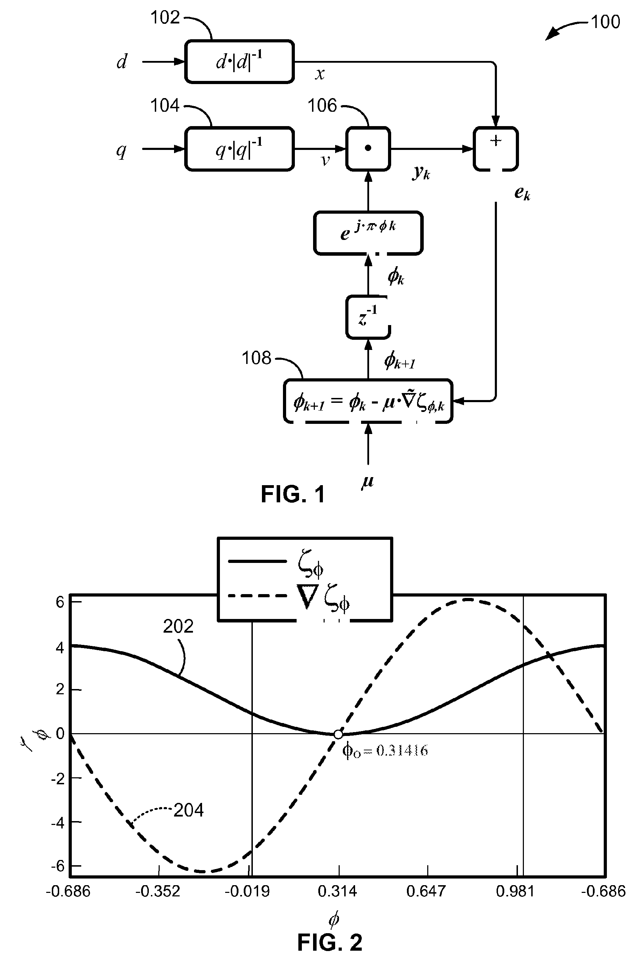

FIG. 1 is a schematic block diagram showing the overall architecture of an exemplary adaptive phase estimation (PE) filter, designated generally as 100. The PE filter 100 differential architecture estimates the phase difference between a complex primary signal and a complex incident signal, iteratively adapting the phase of a complex exponential by minimizing the $L_2$ norm of a complex error signal.

Complex primary signal, $d$, and complex incident signal, $q$, are external inputs to the PE filter. The complex primary signal $d$ and complex incident signal $q$ may be time-varying sampled sequences, or they may more simply consist of two independent complex inputs. Temporal sequences are a special case of the more generalized independent inputs solution, and phase estimates are generally independent of previous estimates. As a matter of convenience and simplicity, the PE filter is described in terms of independent and non-sequential signals. However, the PE filter is not so limited.

Normalized complex primary signal, $x$, and normalized complex incident signal, $v$, are representations of external complex primary and complex incident signals, respectively, normalized to unity magnitude.

Complex reference signal, $y_k$, is the product of a complex exponential of an iterative normalized phase estimate, $\phi_k$, and the normalized complex incident signal, $v$. Multiple iterations of the normalized phase estimate, per input sample pair, may be required to achieve the specified estimation accuracy.

Complex error signal, $e_k$, is the difference between the normalized complex primary signal, x, and the complex reference signal, $y_k$.

Normalized phase, $\phi_k$, is iteratively adapted to minimize the $L_2$ norm of the complex error, $e_k$, which occurs when the normalized phase approximates the normalized phase difference between the complex primary signal, $d$, and the complex incident signal, $q$.

The PE filter differential architecture illustrated in FIG. 1 requires low computational and developmental complexity. Performance surface gradient estimations are relatively simple, and the implicit requirement to support complex exponential synthesis as a function of normalized phase imposes a negligible computational burden, typically in the form of a linear indexed table. The PE filter can support simple, practical implementation in environments with minimal computational resources.

An external complex primary signal, d, is normalized at block 102 to construct a unity magnitude normalized complex primary signal, x, as seen in equation **(1.10),** below.

$$x = \frac{d}{|d|} = d \cdot \left( |d|^2 \right)^{-0.5} = d \cdot \left( d_{RE}^2 + d_{IM}^2 \right)^{-0.5} \tag{1.10}$$

An external complex incident signal, $q$, is normalized at block 104 to construct a unity magnitude normalized complex incident signal, v, as seen in equation (1.11), below.

$$v = \frac{q}{|q|} = q \cdot \left( |q|^2 \right)^{-0.5} = q \cdot \left( q_{RE}^2 + q_{IM}^2 \right)^{-0.5} \tag{1.11}$$

Complex normalization of the complex primary signal, d, and complex incident signal, $q$, preserves phase and frequency content, and eliminates magnitude variation. Division of a complex signal by the square root of its magnitude squared is implicit in complex normalization. Efficient complex normalization approximation is typically required to support implementation in computationally restrictive environments, including systems with real-time response constraints, and systems without efficient native or functional support for division or square root operations.

An iterative application of Newton's method for inverse square root approximation, applied to the squared magnitude of the complex primary and complex incident signals, eliminates the necessity to directly support division or square root operations. Complex normalization approximation is discussed in detail below.

The complex reference signal, $y_k$, is constructed at block 106 as the product of the normalized complex incident signal, v, and a complex exponential which operates on an adaptive normalized phase, $\phi_k$, as seen in equation **(1.12).**

$$y_k = v \cdot e^{j \cdot \pi \cdot \phi_k} = v \cdot \left( \cos\left( \pi \cdot \phi_k \right) + j \cdot \sin\left( \pi \cdot \phi_k \right) \right) = y_{RE,k} + j \cdot y_{IM,k} \tag{1.12}$$

Multiple iterations of the phase estimation are typically required per sample of the complex primary and complex incident signals to achieve a specified accuracy. Normalized phase iteration quantity, K, is an application-dependent limit defining the quantity of iterative normalized phase estimates, with index, k, to be determined per sample of the complex primary and complex incident signals.

In environments where efficient complex exponential synthesis is not available, the complex exponential operation may be accurately and efficiently approximated in the form of an indexed table, at any resolution required, limited only by available storage and numerical representation.

The initial normalized phase, $\phi_0$, is assigned a value that approximates the phase difference between the normalized complex primary signal and the normalized complex incident signal, as seen in equation **(1.13)**.

$$\boldsymbol{\phi}_0 \approx \phi_x - \phi_v \approx -0.5 \cdot \left(1 - \left(x \square\ v\right)\right) \cdot \text{SIGN}\left(x \otimes v\right) \qquad (1.13)$$

A reasonably good initial normalized phase estimate is often important to reduce the normalized phase iteration quantity necessary to obtain the specified estimation accuracy. A linear indexed table can be used in place of the provided relation, though the means of determining an index may require comparable effort. Alternatively, if the complex primary and complex incident signals consist of time-varying sampled sequences, the initial normalized phase estimate may be approximated by the final normalized phase estimate corresponding to the previous input sample pair.

### Normalized Phase Adaptation

A performance surface is a concept that defines a positive real contiguously differentiable function of the adaptive parameters of a system, which possesses an absolute minimum at the optimum adaptive parameter solution. Further, we may elect to require the performance surface be convex, eliminating the definition of local minima that would otherwise interfere with convergence about the optimum adaptive parameter solution.

Gradient descent adaptation is based on the principle of iteratively estimating the gradient of the performance surface, and updating the adaptive parameters to traverse the performance surface in the opposite direction to the gradient estimate. The performance surface for a specific system is generally not known *a priori.* However, an accurate and often efficient gradient estimate may be constructed, revealing a path to the minimum of the performance surface, which corresponds to the optimum adaptive parameter solution.

The performance surface is generally defined as a function of error, or a measure of success in reconciling signals of interest, which is itself a function of the adaptive parameters of a system. It is often productive to develop alternative performance surface and error definitions, as these definitions affect both the computational complexity and practical considerations related to implementation, as well as important functional concerns including convergence and misadjustment.

Definition of a suitable error function is subjective, though certain constraints are required to accommodate the application of gradient descent adaptation. To form an adaptation rule for the normalized phase, the error function must be a contiguously differentiable function of the normalized phase, and possess a single root at an optimum normalized phase selection.

### Complex Difference Error

Equation **(1.14),** which substitutes equation **(1.12),** indicates that a complex error signal, $e_k$, is the complex difference between the normalized complex primary signal, x, and the normalized complex reference signal, $y_k$.

$$\boldsymbol{e}_k = x - \boldsymbol{y}_k = x - v \cdot e^{j \cdot \pi \cdot \boldsymbol{\phi}_k} \qquad (1.14)$$

The error can be minimized in a least squares sense when the complex reference signal closely approximates the normalized complex primary signal. The minimum error condition is achieved when the normalized phase converges to an optimum solution, where the normalized phase approximates the difference in phase between the complex primary and complex incident signals.

The PE filter performance surface, $\zeta_{\phi,k}$, is equal to the product of the complex error and the conjugate complex error, and forms a real convex function of the normalized phase, with a global minimum at the optimum normalized phase solution. This relationship can be seen in equation **(1.15),** which substitutes equations **(1.14)** and **(1.4).**

$$\begin{aligned} \boldsymbol{\zeta}_{\phi,k} &= \boldsymbol{e}_k \cdot \boldsymbol{e}_k^* \\ &= x \cdot x^* + \boldsymbol{y}_k \cdot \boldsymbol{y}_k^* - 2 \cdot \left(x_{RE} \cdot y_{RE,k} + x_{IM} \cdot y_{IM,k}\right) \\ &= |x|^2 + |\boldsymbol{y}_k|^2 - 2 \cdot \left(x \square\ \boldsymbol{y}_k\right) \end{aligned} \qquad (1.15)$$

The partial derivative of the complex reference signal, $y_k$, with respect to the normalized phase provides a convenient simplification of the subsequent definitions of the gradient of the performance surface, as seen in equation (1.16).

$$
\begin{aligned}
\frac{\partial}{\partial \phi}\left(y_k\right) &= \frac{\partial}{\partial \phi}\left(y_{RE,k}\right) + j \cdot \frac{\partial}{\partial \phi}\left(y_{IM,k}\right) \\
&= v \cdot \pi \cdot \left(-\mathrm{SIN}\left(\pi \cdot \phi_k\right) + j \cdot \mathrm{COS}\left(\pi \cdot \phi_k\right)\right) \\
&= \pi \cdot \left(-y_{IM,k} + j \cdot y_{RE,k}\right)
\end{aligned}
\qquad (1.16)
$$

The gradient of the performance surface, $\tilde{\nabla}\zeta_{\phi,k}$, is the vector on the performance surface at coordinates corresponding to the normalized phase, with an orientation corresponding to the direction of greatest increase, and a magnitude equal to the greatest rate of change. This relationship can be seen in equation **(1.17)**, which substitutes equations **(1.16)** and **(1.5)**.

$$
\begin{aligned}
\tilde{\nabla}\zeta_{\phi,k} &= \frac{\partial}{\partial \phi}\left(\zeta_{\phi,k}\right) \\
&= -2 \cdot \left(x_{RE} \cdot \frac{\partial}{\partial \phi}\left(y_{RE,k}\right) + x_{IM} \cdot \frac{\partial}{\partial \phi}\left(y_{IM,k}\right)\right) \\
&= 2 \cdot \pi \cdot \left(x \otimes y_k\right)
\end{aligned}
\qquad (1.17)
$$

The PE filter performance surface is a real function of the normalized phase. The gradient of the performance surface is therefore expressed in terms of the partial derivative of the performance surface with respect to the normalized phase.

The normalized phase can be iteratively adapted at block 108 by applying a Least Mean Square (LMS) update rule, such that the unit advanced normalized phase iteration, $\phi_{k+1}$, is equal to the present normalized phase, $\phi_k$, minus an estimate of the gradient of the performance surface, $\tilde{\nabla}\zeta_{\phi,k}$, scaled by a constant rate of adaptation, $\mu$, as seen in equation **(1.18)**, which substitutes equation **(1.17)**.

$$
\phi_{k+1} = \phi_k - \mu \cdot \tilde{\nabla}\zeta_{\phi,k} = \phi_k - 2 \cdot \pi \cdot \mu \cdot \left(x \otimes y_k\right)
\qquad (1.18)
$$

The selection of an appropriate rate of adaptation is important, as the rate of adaptation is generally inversely proportional to the time constant of convergence and proportional to the misadjustment. Experimental results suggest that the maximum rate of adaptation is approximately 0.05, which can be seen below in **(1.19)**.

$$
\mu \le 0.05
\qquad (1.19)
$$

The performance surface synthesized from an exemplary PE filter is illustrated in FIG. 2. A complex primary signal is constructed with random non-zero magnitude and a normalized phase equal to $0.1 \cdot \pi$. The complex incident signal is assigned a constant value of unity, and provides an absolute phase reference. The normalized phase is specified over a linearly sampled range in [-1.0, 1.0]. The solid trace 202 in FIG. 2 depicts the performance surface, whereas the dashed trace 204 depicts the gradient of the performance surface with respect to normalized phase.

The performance surface is specific to the complex primary signal, and illustrates the presence of a global minimum, $\phi_o$, when the normalized phase is equal to the normalized phase difference between the complex primary signal, $d$, and complex incident signal, $q$. Normalized phase is contiguous across its defined range, as depicted by the light vertical trace at $\pm 1$.

### *Normalized Phase Estimation*

Normalized phase, $\phi$, is equal to the estimated normalized phase, $\phi_k$, evaluated after K successive update iterations, which is shown below in **(1.20).** The normalized phase approximates the normalized phase difference between the complex primary and complex incident signals.

$$\phi = \boldsymbol{\phi}_k \bigg|_{k=K} \qquad (1.20)$$

A PE filter is repetitively applied to extract the normalized phase of a synthetic complex primary signal constructed of a sequence with random non-zero magnitude, and normalized phase specified over a linearly sampled range in [-1, 1]. A complex incident signal is assigned a constant value of unity, and provides an absolute phase reference. The normalized phase is estimated with an iteration quantity, K, defined over the range in [1, 15].

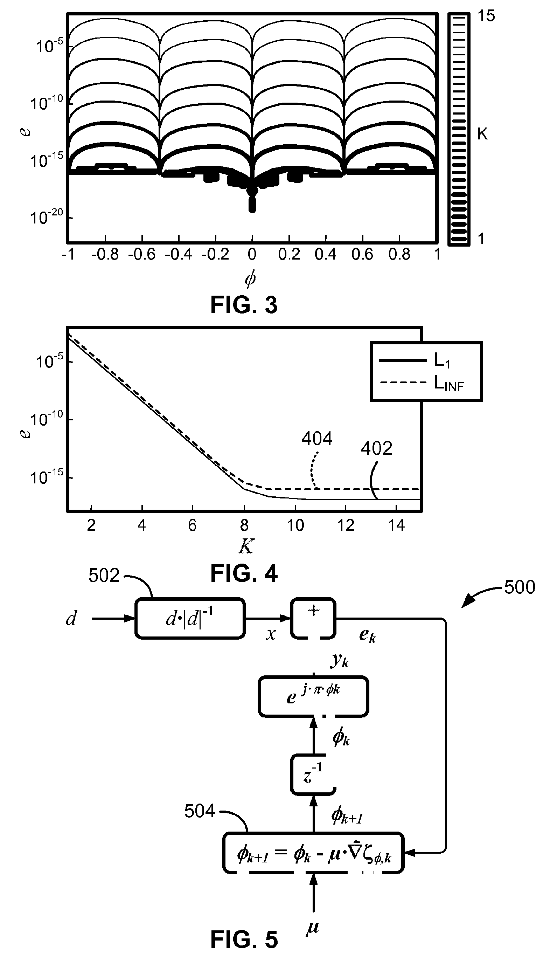

The normalized phase estimation absolute error is the magnitude of the difference between the known normalized phase of the complex primary signal and the estimated normalized phase. An exemplary normalized phase estimation absolute error is illustrated in FIG. 3 on a logarithmic scale over the contiguous range of normalized phase. Darker shaded traces in FIG. 3 correspond to higher normalized phase iteration quantity, and demonstrate lower normalized phase estimation error. Conversely, lighter shaded traces in FIG. 3 correspond to lower normalized phase iteration quantity. Due to the utilization of a logarithmic scale, zero error conditions are not depicted.

With normalized phase iteration quantity, K, equal to 4, the $L_\infty$ norm of the normalized phase estimation error is on the scale of $7.2 \cdot 10$-9, which equates to a maximum normalized phase estimation error of approximately $2.3 \cdot 10$-9 radians. The $L_1$ norm, which is representative of mean normalized phase estimation error, is at least one order of magnitude smaller across the complete phase range.

Exemplary $L_1$ and $L_\infty$ norms of the complex normalized phase estimation error are illustrated in FIG. 4 on a logarithmic scale over the normalized phase iteration quantity, K, defined over the range in [1, 15]. The solid trace 402 depicts the $L_1$ norm, whereas the dashed trace 404 depicts the $L_\infty$ norm with respect to the normalized phase iteration quantity.

It is possible to select the normalized phase iteration quantity to ensure that the $L_1$ or $L_\infty$ norm of the resulting normalized phase estimation error is within acceptable bounds for an application in a specific environment. Computational complexity is proportional to normalized phase iteration quantity, K.

The $L_1$ or $L_\infty$ norm of the normalized phase estimation error generally decrease exponentially with respect to increasing normalized phase iteration quantity, at a rate equal to approximately 6.2 bits of increase in dynamic range per iteration. At a normalized phase iteration quantity greater than 8, the reduction in estimation error is negligible, and the error is bound at the limit by other existing sources of error, including misadjustment, numerical representation, and finite word length effects.

At the limit, the dynamic range of a numerical representation is insufficient to represent the accuracy promised by an incrementally larger polynomial segment length. A signed error on the scale of $3.8 \cdot 10$-9, as observed at normalized phase iteration quantity equal to 4, represents over 28 bits of dynamic range. A normalized phase iteration quantity greater than or equal to 8 results in signed error on the scale of $1.0 \cdot 10^{-16}$, representing over 54 bits of dynamic range.

## Absolute Phase Estimation

FIG. 5 is a schematic block diagram showing the overall architecture of an exemplary absolute PE filter, which is designated generally as 500. The PE filter absolute architecture estimates the absolute phase of a complex primary signal, iteratively adapting the phase of a complex exponential by minimizing the $L_2$ norm of a complex error signal.

Complex primary signal, d, is an external input to the PE filter. The complex primary signal may be a time-varying sampled sequence, or in some instances may simply consist of an independent complex input. Temporal sequences are a special case of the more generalized independent input solution, and phase estimates are generally independent of previous estimates. As a matter of convenience and simplicity, the PE filter is described in terms of an independent and non-sequential complex primary signal.

Normalized complex primary signal, x, is a representations of an external complex primary signal, *d*, normalized at block 502 to unity magnitude.

Complex reference signal, $\boldsymbol{y}_k$, is a complex exponential of an iterative normalized phase estimate, $\phi_k$. Multiple iterations of the normalized phase estimate, per input sample, may be required to achieve the specified estimation accuracy.

Complex error signal, $\boldsymbol{e}_k$, is the difference between the normalized complex primary signal, x, and the complex reference signal, $\boldsymbol{y}_k$.

Normalized phase, $\phi_k$, is iteratively adapted to minimize the $L_2$ norm of the complex error, $\boldsymbol{e}_k$, which occurs when the normalized phase approximates the absolute normalized phase of the complex primary signal, *d*.

The PE filter absolute architecture is substantially equivalent to the differential architecture, with a significant simplification: the complex incident signal is assigned a constant value of unity, resulting in an absolute normalized phase estimation of the complex primary signal relative to zero phase.

The PE filter absolute architecture generally requires low computational and developmental complexity, requiring one fewer complex normalization operation and complex multiplication, relative to the differential architecture.

A simplified complex reference signal, $y_k$, is constructed as a complex exponential which operates on an adaptive normalized phase, $\phi_k$, as seen in equation **(1.21).**

$$y_k = e^{j \cdot \pi \cdot \phi_k} = \left( \cos\left( \pi \cdot \phi_k \right) + j \cdot \sin\left( \pi \cdot \phi_k \right) \right) = y_{RE,k} + j \cdot y_{IM,k} \qquad (1.21)$$

Normalized phase is iteratively adapted at block 504 by applying an LMS update rule, such that the unit advanced normalized phase iteration, $\phi_{K+1}$, is equal to the present normalized phase, $\phi_k$, minus an estimate of the gradient of the performance surface, $\tilde{\nabla}_{\zeta_{\phi,k}}$, scaled by a constant rate of adaptation, $\mu$. Normalized phase is updated according to equations **(1.18)** and **(1.20),** and substituting equation **(1.21).**

## APPROXIMATION AND SYNTHESIS

Development of the complex adaptive PE filter may require the construction of efficient alternatives to the divide operation implicit in complex normalization. An efficient approximation to complex normalization is developed to support practical PE filter implementation in computationally restrictive environments, including systems with real-time response constraints, and systems without efficient native or functional support for division or square root operations.

### Complex Normalization Approximation

Complex normalization approximation is typically a function that operates on a complex input, and produces an output equal to the complex input divided by the magnitude of the complex input. Complex normalization preserves phase and frequency content, and eliminates magnitude variation.

An iterative application of Newton's method for inverse square root approximation, applied to the squared magnitude of the complex input, eliminates the necessity to directly support division or square root operations.

The magnitude squared of the complex input, x, is designated as a complex input magnitude squared, v, in equation **(2.1),** below.

$$v = \left| x \right|^2 = x \cdot x^*\qquad (2.1)$$

An iterative Newton's method inverse square root approximation is applied to the complex input magnitude squared, v, and multiplied by the complex input, x, to produce a complex output, y, with unity magnitude and phase corresponding to the complex input, as seen in equation **(2.2),** which substitutes equation **(2.1).**

$$y \approx \frac{x}{\left| x \right|} = x \cdot \left( \left| x \right|^2 \right)^{-0.5} = x \cdot v^{-0.5}\qquad (2.2)$$

An indexed inverse square root approximation table, $u_k$, with index, *k,* is synthesized to provide a low resolution initial approximation to the inverse square root of an arbitrary real input, as seen in equation **(2.3).** The table provides initial values for subsequent application of Newton's method, which reduces the iteration quantity required to achieve a specified accuracy, and increases the probability of convergence.

$$u_k = \left( \frac{k \cdot R^2}{K} \right)^{-0.5} \qquad\qquad k : \left[ 0, K-1 \right] \qquad (2.3)$$

The table accommodates positive arguments corresponding to the magnitude squared of complex inputs, in the range $[0, R^2]$. Therefore, the magnitude of supported complex inputs is in the range $[0, R]$, with a resolution determined by the table length, $K$.

Selection of the complex input magnitude range is often based on *a priori* knowledge, and table length can be selected, for example, by considering the available memory and computational resources. A larger table will generally require more memory, and generally less iterations, and computational expense, to achieve the required approximation accuracy.

The inverse square root approximation table is a linear indexed array with index, k, equal to the table location that most closely corresponds to a specific complex input magnitude squared. The complex input magnitude squared is scaled by the table gain, or the inverse of the table resolution, and rounded to the nearest integer in the range of table indices, as indicated in equation **(2.4).**

$$k = \mathrm{MIN}\left(\left\lfloor v \cdot \left(\frac{K}{R^2}\right) + 0.5 \right\rfloor, K - 1\right) \qquad\qquad \textbf{(2.4)}$$

The initial inverse square root approximation, $q_0$, is equal to the inverse square root approximation table value at the index extracted from a specific complex input magnitude squared, *v*, in **(2.5).**

$$q_0 = \boldsymbol{u}_k \approx v^{-0.5} \qquad\qquad \textbf{(2.5)}$$

The inverse square root approximation, $q_m$, is the iterative approximation with index, *m*, of Newton's method iteration quantity, *M.* The iterative inverse square root approximation is a recursive function of the previous inverse square root approximation iteration, $q_{m-1}$, and the complex input magnitude squared. This relationship can be seen in equation (2.6), below.

$$q_m = 0.5 \cdot q_{m-1} \cdot \left(3.0 - v \cdot q_{m-1}^2\right) \qquad\qquad m:\left[1, M\right] \qquad \textbf{(2.6)}$$

Newton's method is not guaranteed to converge, though a good initial guess, provided by a sufficiently high resolution approximation table, virtually ensures convergence for values in the supported range. The quantity of iterations required is dependent, for example, upon the necessary accuracy of the approximation. Analysis to determine the quantity of iterations required should consider issues including error tolerance of dependent consumers of the approximations, and numerical representations or finite word-length effects.

An alternative implementation may specify a maximum Newton's method iteration quantity, and define a stopping case to terminate iteration when the change in successive approximations is too small to justify additional operations, though the expense of additional comparisons and conditional branches must be considered.

As seen in equation **(2.7),** the complex normalization approximation, *y*, is equal to the product of the complex input, x, and the final Newton's method inverse square root approximation, $q_M$.

$$y = x \cdot q_M \approx \frac{x}{|x|} \qquad\qquad \textbf{(2.7)}$$

Pathological cases for the complex normalization approximation include complex inputs whose magnitude squared is sufficiently proximate to zero. A small threshold, perhaps equal to the resolution of the inverse square root approximation table, should be used to test the complex input magnitude squared, and assign a default complex output, perhaps unity, when such conditions are observed.

A result indicating negative inverse square root approximation iteration may be identified as a failure to converge, perhaps due to a complex input whose magnitude significantly exceeds the supported range.

**Claims**

1.  A method (100) of estimating a phase difference between a complex primary signal (d) and a complex incident signal (q), the method comprising:

    determining (102) a normalized complex primary signal (x) based, at least in part, on the complex primary signal (d);

determining (104) a normalized complex incident signal (v) based, at least in part, on the complex incident signal (q);

determining (106) a complex reference signal $(y_k)$, the complex reference signal being the product of the normalized complex incident signal (v) and a complex exponential $(e^{j\pi\varphi k})$;

determining a complex error signal $(e_k)$, the complex error signal being the difference between the normalized complex primary signal (x) and the complex reference signal $(y_k)$;

iteratively adapting (108) a phase of the complex exponential $(e^{j\pi\varphi k})$ by minimizing a norm of the complex error signal $(e_k)$; and

storing, in at least one memory, an indication of the phase difference between the complex primary signal (d) and the complex incident signal (q) when the norm of the complex error signal (ek) is minimized.

2. The method of claim 1, further comprising:

normalizing the complex primary signal to produce a normalized complex primary signal (102);

normalizing the complex incident signal to produce a normalized complex incident signal (104) ;

multiplying the normalized complex incident signal by the complex exponential to produce a complex reference signal (106); and

calculating a complex difference between the complex reference signal and the normalized complex primary signal to produce the complex error signal (108).

3. The method of claim 1, wherein the mean squared error norm of the complex error signal is minimized responsive to the complex reference signal closely approximating the normalized complex primary signal.

4. The method of any preceding claim, wherein the phase is normalized, the method further comprising determining that the mean squared error norm of the complex error signal is minimized responsive to the normalized phase closely approximating a normalized phase difference between the complex primary signal and the complex incident signal.

5. The method of claim 4, wherein the normalized phase is initialized to an initial normalized phase, a value of the initial normalized phase approximating the phase difference between the normalized complex primary signal and the normalized complex incident signal.

6. The method of claim 2, wherein the normalizing the complex primary signal and the normalizing the complex incident signal are carried out without performing any division or square root operations by a complex normalization approximation that includes iteratively applying an inverse square root approximation to the complex primary signal and to the complex incident signal.

7. The method of any preceding claim , wherein the iteratively adapting is carried out without performing any division or square root operations.

8. The method of any preceding claim, wherein the complex primary signal and the complex incident signals are time-varying sampled sequences and are independent and non-sequential signals relative to one another.

9. The method of any preceding claim, wherein the minimizing is carried out using a gradient of a performance surface (204) scaled by a constant rate of adaptation.

10. The method of claim 9, wherein the constant rate of adaptation does not exceed 0.05.

11. The method of claim 9, wherein the phase is normalized and wherein the minimizing includes subtracting the gradient of the performance surface (204) scaled by the constant rate of adaptation from a present iteration of the normalized phase.

12. The method of claim 11, wherein the performance surface achieves a global minimum responsive to the normalized phase closely approximating the normalized phase difference between the complex primary signal and the complex incident signal.

13. The method of any preceding claim, further comprising assigning the complex incident signal a constant value of unity such that the phase difference corresponds to an absolute normalized phase estimation of the complex primary signal relative to zero phase.

14. The method of any preceding claim, wherein the determining the normalized complex primary signal includes normalizing the complex primary signal to unity magnitude, and wherein the determining the normalized complex incident signal includes normalizing the complex incident signal to unity magnitude.

**Patentansprüche**

1. Ein Verfahren (100) zum Einschätzen einer Phasendifferenz zwischen einem komplexen primären Signal (d) und einem komplexen einfallenden Signal (q), wobei das Verfahren Folgendes beinhaltet:

Bestimmen (102) eines normalisierten komplexen primären Signals (x), basierend, zumindest teilweise, auf dem komplexen primären Signal (d);
Bestimmen (104) eines normalisierten komplexen einfallenden Signals (v), basierend, zumindest teilweise, auf dem komplexen einfallenden Signal (q);
Bestimmen (106) eines komplexen Referenzsignals ($y_k$), wobei das komplexe Referenzsignal das Produkt des normalisierten komplexen einfallenden Signals (v) und einer komplexen Exponentiellen ($e^{j\pi\varphi k}$) ist;
Bestimmen eines komplexen Fehlersignals ($e_k$), wobei das komplexe Fehlersignal die Differenz zwischen dem normalisierten komplexen primären Signal (x) und dem komplexen Referenzsignal ($y_k$) ist;
iteratives Anpassen (108) einer Phase der komplexen Exponentiellen ($e^{j\pi\varphi k}$) durch Minimieren einer Norm des komplexen Fehlersignals ($e_k$); und
Speichern, in mindestens einem Speicher, einer Angabe der Phasendifferenz zwischen dem komplexen primären Signal (d) und dem komplexen einfallenden Signal (q), wenn die Norm des komplexen Fehlersignals ($e_k$) minimiert ist.

2. Verfahren gemäß Anspruch 1, das weiter Folgendes beinhaltet:

Normalisieren des komplexen primären Signals zum Erzeugen eines normalisierten komplexen primären Signals (102);
Normalisieren des komplexen einfallenden Signals zum Erzeugen eines normalisierten komplexen einfallenden Signals (104);
Multiplizieren des normalisierten komplexen einfallenden Signals mit der komplexen Exponentiellen zum Erzeugen eines komplexen Referenzsignals (106); und
Berechnen einer komplexen Differenz zwischen dem komplexen Referenzsignal und dem normalisierten komplexen primären Signal zum Erzeugen des komplexen Fehlersignals (108).

3. Verfahren gemäß Anspruch 1, wobei die Norm des mittleren quadratischen Fehlers des komplexen Fehlersignals reagierend auf das komplexe Referenzsignal, das sich stark an das normalisierte komplexe primäre Signal annähert, minimiert wird.

4. Verfahren gemäß einem der vorhergehenden Ansprüche, wobei die Phase normalisiert ist, wobei das Verfahren weiter das Bestimmen, dass die Norm des mittleren quadratischen Fehlers des komplexen Fehlersignals reagierend auf die normalisierte Phase, die sich stark an eine normalisierte Phasendifferenz zwischen dem komplexen primären Signal und dem komplexen einfallenden Signal annähert, beinhaltet.

5. Verfahren gemäß Anspruch 4, wobei die normalisierte Phase auf eine anfängliche normalisierte Phase initialisiert wird, wobei sich ein Wert der anfänglichen normalisierten Phase der Phasendifferenz zwischen dem normalisierten komplexen primären Signal und dem normalisierten komplexen einfallenden Signal annähert.

6. Verfahren gemäß Anspruch 2, wobei das Normalisieren des komplexen primären Signals und das Normalisieren des komplexen einfallenden Signals ohne das Durchführen einer Divisions- oder Quadratwurzeloperation mittels einer komplexen Normalisierungsannäherung, welche das iterative Anwenden einer inversen Quadratwurzelannäherung an das komplexe primäre Signal und das komplexe einfallende Signal umfasst, vorgenommen werden.

7. Verfahren gemäß einem der vorhergehenden Ansprüche, wobei das iterative Anpassen ohne das Durchführen einer Divisions- oder Quadratwurzeloperation vorgenommen wird.

8. Verfahren gemäß einem der vorhergehenden Ansprüche, wobei das komplexe primäre Signal und die komplexen einfallenden Signale zeitlich variierende abgetastete Sequenzen sind und unabhängige und nicht-sequenzielle Signale relativ zueinander sind.

9. Verfahren gemäß einem der vorhergehenden Ansprüche, wobei das Minimieren unter Verwendung eines Gradienten einer Leistungsoberfläche (204), skaliert durch eine konstante Anpassungsrate, vorgenommen wird.

10. Verfahren gemäß Anspruch 9, wobei die konstante Anpassungsrate 0,05 nicht übersteigt.

11. Verfahren gemäß Anspruch 9, wobei die Phase normalisiert ist und wobei das Minimieren das Subtrahieren des Gradienten der Leistungsoberfläche (204), skaliert durch eine konstante Anpassungsrate, von einer gegenwärtigen Iteration der normalisierten Phase umfasst.

12. Verfahren gemäß Anspruch 11, wobei die Leistungsoberfläche einen globalen Mindestwert erreicht, der auf die normalisierte Phasendifferenz reagiert, die sich stark an die normalisierte Phasendifferenz zwischen dem komplexen primären Signal und dem komplexen einfallende Signal annähert.

13. Verfahren gemäß einem der vorhergehenden Ansprüche, das weiter das Zuweisen eines konstanten Werts von Einheit zu dem komplexen einfallenden Signal beinhaltet, sodass die Phasendifferenz einer absoluten normalisierten Phaseneinschätzung des komplexen primären Signals relativ zu einer Nullphase entspricht.

14. Verfahren gemäß einem der vorhergehenden Ansprüche, wobei das Bestimmen des normalisierten komplexen primären Signals das Normalisieren des komplexen primären Signals auf eine Einheitengrößenordnung umfasst, und wobei das Bestimmen des normalisierten komplexen einfallenden Signals das Normalisieren des komplexen einfallenden Signals auf eine Einheitengrößenordnung umfasst.

## Revendications

1. Une méthode (100) d'estimation d'une différence de phase entre un signal primaire complexe (d) et un signal incident complexe (q), la méthode comprenant :

   la détermination (102) d'un signal primaire complexe normalisé (x) basé, au moins en partie, sur le signal primaire complexe (d) ;
   la détermination (104) d'un signal incident complexe normalisé (v) basé, au moins en partie, sur le signal incident complexe (q) ;
   la détermination (106) d'un signal de référence complexe ($y_k$), le signal de référence complexe étant le produit du signal incident complexe normalisé (v) et d'une exponentielle complexe ($e^{j\pi\phi\kappa}$) ;
   la détermination d'un signal d'erreur complexe ($e_k$), le signal d'erreur complexe étant la différence entre le signal primaire complexe normalisé (x) et le signal de référence complexe ($y_k$) ;
   l'adaptation de façon itérative (108) d'une phase de l'exponentielle complexe ($e^{j\pi\phi\kappa}$) en minimisant une norme du signal d'erreur complexe ($e_k$) ; et
   le stockage, dans au moins une mémoire, d'une indication de la différence de phase entre le signal primaire complexe (d) et le signal incident complexe (q) lorsque la norme du signal d'erreur complexe (ek) est minimisée.

2. La méthode de la revendication 1, comprenant en outre :

   la normalisation du signal primaire complexe pour produire un signal primaire complexe normalisé (102) ;
   la normalisation du signal incident complexe pour produire un signal incident complexe normalisé (104) ;
   la multiplication du signal incident complexe normalisé par l'exponentielle complexe pour produire un signal de référence complexe (106) ; et
   le calcul d'une différence complexe entre le signal de référence complexe et le signal primaire complexe normalisé pour produire le signal d'erreur complexe (108).

3. La méthode de la revendication 1, dans laquelle la norme d'erreur quadratique moyenne du signal d'erreur complexe est minimisée en réponse au signal de référence complexe qui se rapproche étroitement du signal primaire complexe normalisé.

4. La méthode de n'importe quelle revendication précédente, dans laquelle la phase est normalisée, la méthode comprenant en outre la détermination du fait que la norme d'erreur quadratique moyenne du signal d'erreur complexe est minimisée en réponse à la phase normalisée qui se rapproche étroitement d'une différence de phase normalisée entre le signal primaire complexe et le signal incident complexe.

5. La méthode de la revendication 4, dans laquelle la phase normalisée est initialisée sur une phase normalisée initiale, une valeur de la phase normalisée initiale se rapprochant de la différence de phase entre le signal primaire complexe normalisé et le signal incident complexe normalisé.

6. La méthode de la revendication 2, dans laquelle la normalisation du signal primaire complexe et la normalisation du signal incident complexe sont effectuées sans réaliser d'opérations de division ou racine carrée quelconques par une approximation de normalisation complexe qui inclut l'application de façon itérative d'une approximation de racine carrée inverse sur le signal primaire complexe et sur le signal incident complexe.

7. La méthode de n'importe quelle revendication précédente, dans laquelle l'adaptation de façon itérative est effectuée sans réaliser d'opérations de division ou racine carrée quelconques.

8. La méthode de n'importe quelle revendication précédente, dans laquelle le signal primaire complexe et les signaux incidents complexes sont des séquences échantillonnées variables dans le temps et sont des signaux indépendants et non séquentiels les uns par rapport aux autres.

9. La méthode de n'importe quelle revendication précédente, dans laquelle la minimisation est effectuée en utilisant un gradient d'une surface de performance (204) mise à l'échelle par un taux constant d'adaptation.

10. La méthode de la revendication 9, dans laquelle le taux constant d'adaptation ne dépasse pas 0,05.

11. La méthode de la revendication 9, dans laquelle la phase est normalisée et dans laquelle la minimisation inclut la soustraction du gradient de la surface de performance (204) mise à l'échelle par le taux constant d'adaptation à partir d'une itération présente de la phase normalisée.

12. La méthode de la revendication 11, dans laquelle la surface de performance atteint un minimum global en réponse à la phase normalisée qui se rapproche étroitement de la différence de phase normalisée entre le signal primaire complexe et le signal incident complexe.

13. La méthode de n'importe quelle revendication précédente, comprenant en outre l'assignation au signal incident complexe d'une valeur constante d'unité de telle sorte que la différence de phase corresponde à une estimation de phase normalisée absolue du signal primaire complexe relativement à une phase zéro.

14. La méthode de n'importe quelle revendication précédente, dans laquelle la détermination du signal primaire complexe normalisé inclut la normalisation du signal primaire normalisé sur une amplitude d'unité, et dans laquelle la détermination du signal incident complexe normalisé inclut la normalisation du signal incident complexe sur une amplitude d'unité.

**FIG. 1**

**FIG. 2**

**FIG. 3**

**FIG. 4**

**FIG. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090287463 A